# EUROPEAN PATENT SPECIFICATION

(11) **EP 3 872 237 B1**
(45) Date of publication and mention of the grant of the patent: **26.07.2023**
(21) Application number: 19875809.6
(22) Date of filing: 20.09.2019
(51) Int. Cl.: C25D 5/34, C23C 14/14, C23C 14/56, H05K 3/18, H05K 3/26, C25D 5/56, C23C 14/02, C23C 14/20, C25D 5/10, C25D 7/06, C25D 17/00, H05K 1/03, H05K 3/02

(54) **APPARATUS AND METHOD FOR MANUFACTURING RESIN FILM PROVIDED WITH METAL MEMBRANE**
VORRICHTUNG UND VERFAHREN ZUR HERSTELLUNG EINER MIT EINER METALLMEMBRAN VERSEHENEN HARZFOLIE
APPAREIL ET PROCÉDÉ DE FABRICATION D'UN FILM DE RÉSINE POURVU D'UNE MEMBRANE MÉTALLIQUE

(30) Priority: 23.10.2018 JP 2018199073
(43) Date of publication of application: 01.09.2021
(73) Proprietor: Sumitomo Metal Mining Co., Ltd., Tokyo 105-8716 (JP)
(72) Inventor: OKAMI, Hideharu, Niihama-shi, Ehime 792-0008 (JP)
(74) Representative: TBK
(86) International application number: PCT/JP2019/036977
(87) International publication number: WO 2020/084974

(56) References cited:
- WO-A1-2014/154689
- JP-A- 2009 148 896
- JP-A- 2009 220 386
- JP-A- 2012 149 284

## Description

### TECHNICAL FIELD

The present invention relates to an apparatus for and a method of manufacturing a metal film-coated resin film that can be obtained by forming a metal film by a wet plating method on a metal seed layer on a long resin film, the metal seed layer being deposited on the long resin film by a vacuum deposition method such as sputtering. The present invention particularly relates to an improvement in an apparatus for and a method of manufacturing a metal film-coated resin film that is less prone to formation of defects such as pinholes in a metal film formed on a metal seed layer by a wet plating method.

### BACKGROUND ART

Various types of flexible wiring substrates are used in liquid crystal panels, laptop computers, digital cameras, mobile phones, and so on. As the material of such a flexible wiring substrate, a metal film-coated resin film is used which is a heat-resistant resin film with a metal film formed on one or both of its surfaces. By applying a thin film processing technique such as photolithography or etching to this metal film-coated resin film, a flexible wiring substrate including a predetermined wiring pattern can be obtained. In recent years, the wiring patterns on flexible wiring substrates have increasingly become finer and denser and it has become more important to eliminate defects such as pinholes in the metal films of metal film-coated resin films.

Conventional methods of manufacturing this type of metal film-coated resin film have known such as: a manufacturing method in which a metal foil is attached to a heat-resistant resin film with an adhesive (referred to as the three-layer substrate manufacturing method); a manufacturing method in which a metal foil is coated with a heat-resistant resin solution and then the resin solution is dried (referred to as the casting method); and a method in which a metal film is deposited on a heat-resistant resin film by a vacuum deposition method or a manufacturing method in which a metal seed layer is deposited on a heat-resistant resin film by a vacuum deposition method and a metal film is formed on the metal seed layer by a wet plating method (referred to as the metallizing method). Also, the vacuum deposition method in the metallizing method includes vacuum vapor deposition methods, sputtering methods, ion plating methods, ion beam sputtering methods, and so on. Documents JP2012149284A and JP2009148896A disclose such methods.

As the metallizing method, Patent Document 1 discloses a method in which chromium is sputtered onto a polyimide insulating layer and then copper is sputtered to form a conductive layer on the polyimide insulating layer. Also, Patent Document 2 discloses a flexible circuit board material obtained by laminating a first metal thin film formed by sputtering a target of a copper-nickel alloy and a second metal thin film formed by sputtering a target of copper onto a polyimide film in this order. Note that a sputtering web coater is usually used to perform vacuum deposition on a heat-resistant resin film (substrate) such as a polyimide film.

In recent years, resin films with both surfaces coated with a metal film have been manufactured by the metallizing method as high-density wiring substrates. Specifically, such a resin film with both surfaces coated with a metal film has been manufactured by depositing a metal seed layer on both surfaces of a long heat-resistant resin film by a vacuum deposition method such as sputtering and forming a metal film on each metal seed layer by a wet plating method. Note that the metal seed layers are deposited by using a vacuum deposition apparatus such as a sputtering web coater, and the metal films are formed by using a wet plating apparatus. The resin film with both surfaces coated with the metal films by the metallizing method is therefore manufactured through two steps using different manufacturing apparatuses. Specifically, the long resin film with the metal seed layers deposited thereon by the vacuum deposition apparatus is temporarily wound up in a roll form inside the vacuum deposition apparatus, and then transferred out of the vacuum deposition apparatus into the wet plating bath in the wet plating apparatus to form the metal films on the metal seed layers on the long resin film.

Meanwhile, the surfaces of the metal seed layers immediately after being deposited inside the vacuum deposition apparatus have not been oxidized and are highly active as well. Thus, if the long resin film with the metal seed layers deposited thereon is wound up in a roll form without air interposed in the vacuum deposition apparatus, a blocking phenomenon in which the metal seed layers get attached to each other occurs and the surface of either metal seed layer is locally torn off when the long resin film is unwound from a roll. Note that in the case of a long resin film with a metal seed layer deposited on one surface too, the metal seed layer immediately after being deposited and the back surface side of the long resin film may contact each other and get locally attached to each other if the long resin film is strongly wound up in a roll form without air interposed in the vacuum deposition apparatus.

To avoid this phenomenon, when a long resin film with a metal seed layer deposited thereon is wound up in a roll form, a method has been generally employed in which the long resin film is wound up while a long insertion sheet made of a resin film or the like is inserted between layers of the long resin film.

However, in the method in which a long resin film with a metal seed layer deposited thereon is wound up while a long insertion sheet is inserted between layers of the long resin film, the long insertion sheet contacts the surface of the metal seed layer immediately after being deposited. Consequently, a component of the long insertion sheet (e.g., a resin film component, a solvent component contained in the resin film, or the like) may locally transfer onto the surface of the metal seed layer if the long resin film is strongly wound up in vacuo.

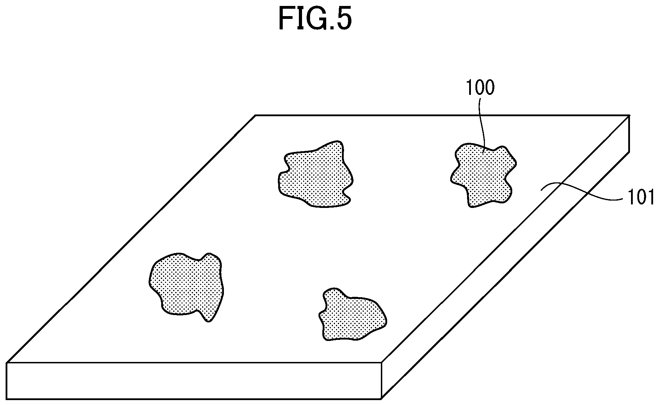

If the long resin film with the component of the long insertion sheet having locally transferred onto the surface of the metal seed layer is unwound from the roll and undergoes the wet plating, there will be a problem in that defects such as pinholes will be formed in the metal film due to a component 100 mentioned above that has transferred onto the surface of a metal seed layer 101 as illustrated in FIG. 5. To address this problem, a method has been considered in which the surface of the metal seed layer 101 undergoes to acid cleaning with a diluted sulfuric acid solution or the like after the long resin film with the component 100 having locally transferred onto the surface of the metal seed layer 101 is unwound from the roll but before the long resin film is transferred into the wet plating bath. However, it is difficult to completely remove the component 100 of the long insertion sheet having transferred onto the surface of the metal seed layer 101 with a diluted sulfuric acid solution or the like, and it is therefore difficult to completely eliminate the formation of pinholes or the like.

Meanwhile, when the long resin film is unwound from the roll, the long insertion sheet (resin film insertion sheet) inserted between layers of the long resin film is separated from the long resin film and is wound up and collected by a long insertion sheet winding roll.

### CONVENTIONAL ART DOCUMENTS

### PATENT DOCUMENTS

Patent Document 1: Japanese Patent Application Publication No. Hei 2-98994
Patent Document 2: Japanese Patent Application Publication No. Hei 6-97616

### SUMMARY OF THE INVENTION

### PROBLEM TO BE SOLVED BY THE INVENTION

The present invention has been made in view of such a problem and an object thereof is to provide an apparatus for and a method of manufacturing a metal film-coated resin film by transferring a long resin film with a metal seed layer deposited on one or both surfaces thereof by a vacuum deposition method into a wet plating bath in a wet plating apparatus to form a metal film on the metal seed layer, atmospheric-pressure plasma cleaning being performed on a surface of the metal seed layer immediately before the long resin film is transferred into the wet plating bath to manufacture a metal film-coated resin film that is less prone to formation of defects such as pinholes in the metal film.

### MEANS FOR SOLVING THE PROBLEM

Specifically, a first aspect according to the present invention is a metal film-coated resin film manufacturing apparatus including:
a long resin film unwinding roll around which a long resin film with a metal seed layer deposited on one or both surfaces thereof is wound up with a long insertion sheet inserted between layers of the long resin film;
a long insertion sheet winding roll which separates the long insertion sheet from the long resin film unwound from the long resin film unwinding roll and winds up the long insertion sheet;
a wet plating bath into which the long resin film from which the long insertion sheet has been separated is transferred to form a metal film on the metal seed layer; and
a long resin film winding roll which winds up the long resin film with the metal film formed thereon,
characterized in that the apparatus includes an atmospheric-pressure plasma cleaning apparatus which cleans a surface of the metal seed layer on the long resin film from which the long insertion sheet has been separated, the atmospheric-pressure plasma cleaning apparatus being provided between the long resin film unwinding roll and the wet plating bath.
A second aspect according to the present invention is the metal film-coated resin film manufacturing apparatus according to the first aspect, characterized in that the metal seed layer and the metal film on the long resin film contain Cu as a main component.
A third aspect according to the present invention is the metal film-coated resin film manufacturing apparatus according to the first aspect, characterized in that the long insertion sheet is made of polyethylene, polypropylene, polyethylene terephthalate, polyethylene naphthalate, polystyrene, polyvinyl alcohol, polycarbonate, polyphenylene sulfide, polyether ether ketone, polyethersulfone, aramid, polyimide, or triacetate alone, or a composite of any of these laminated to each other.
Also, a fourth aspect according to the present invention is the metal film-coated resin film manufacturing apparatus according to the first aspect, characterized in that the atmospheric-pressure plasma cleaning apparatus is of a remotely operated type.

Next, a fifth aspect according to the present invention is a metal film-coated resin film manufacturing method including the steps of:
unwinding a long resin film with a metal seed layer deposited on one or both surfaces thereof from a long resin film unwinding roll around which the long resin film is wound up with a long insertion sheet inserted between layers of the long resin film;
separating the long insertion sheet from the long resin film unwound from the long resin film unwinding roll and winding up the long insertion sheet around a long insertion sheet winding roll;
transferring the long resin film from which the long insertion sheet has been separated into a wet plating bath to form a metal film on the metal seed layer; and
winding up the long resin film with the metal film formed thereon around a long resin film winding roll,
characterized in that the method includes performing atmospheric-pressure plasma cleaning on a surface of the metal seed layer on the long resin film from which the long insertion sheet has been separated, before the long resin film is transferred into the wet plating bath.

A sixth aspect according to the present invention is the metal film-coated resin film manufacturing method according to the fifth aspect, characterized in that the metal seed layer and the metal film on the long resin film contain Cu as a main component.

A seventh aspect according to the present invention is the metal film-coated resin film manufacturing method according to the fifth aspect, characterized in that the long insertion sheet is made of polyethylene, polypropylene, polyethylene terephthalate, polyethylene naphthalate, polystyrene, polyvinyl alcohol, polycarbonate, polyphenylene sulfide, polyether ether ketone, polyethersulfone, aramid, polyimide, or triacetate alone, or a composite of any of these laminated to each other.

Also, an eighth aspect according to the present invention is the metal film-coated resin film manufacturing method according to the fifth aspect, characterized in that an apparatus which performs the atmospheric-pressure plasma cleaning on the surface of the metal seed layer on the long resin film is configured as a remotely operated-type apparatus.

### EFFECTS OF THE INVENTION

In the metal film-coated resin film manufacturing apparatus according to the present invention, the atmospheric-pressure plasma cleaning apparatus, which cleans the surface of the metal seed layer on the long resin film from which the long insertion sheet has been separated, is provided between the long resin film unwinding roll and the wet plating bath. Thus, a component of the long insertion sheet having transferred onto the surface of the metal seed layer can be removed before the long resin film is transferred into the wet plating bath. This enables high-yield manufacturing of a high-quality metal film-coated resin film that is less prone to formation of defects such as pinholes in its metal film formed by a wet plating method.

In the metal film-coated resin film manufacturing method according to the present invention, the atmospheric-pressure plasma cleaning is performed on the surface of the metal seed layer on the long resin film from which the long insertion sheet has been separated, before the long resin film is transferred into the wet plating bath, so that a transferred component of the long insertion sheet is removed from the surface of the metal seed layer. This enables high-yield manufacturing of a high-quality metal film-coated resin film without pinholes or the like in its metal film.

### BRIEF DESCRIPTION OF THE DRAWINGS

[FIG. 1] FIG. 1 is an explanatory diagram of the configuration of a sputtering web coater (vacuum deposition apparatus) for depositing a metal seed layer on one surface of a long resin film.
[FIG. 2] FIG. 2 is an explanatory diagram of the configuration of a sputtering web coater (vacuum deposition apparatus) for depositing a metal seed layer on both surfaces of a long resin film.
[FIG. 3] FIG. 3 is an explanatory diagram of the configuration of a metal film-coated resin film manufacturing apparatus according to a first embodiment of the present invention incorporating an atmospheric-pressure plasma cleaning apparatus between a long resin film unwinding roll and a wet plating bath.
[FIG. 4] FIG. 4 is an explanatory diagram of the configuration of a metal film-coated resin film manufacturing apparatus according to a second embodiment of the present invention incorporating an atmospheric-pressure plasma cleaning apparatus between a long resin film unwinding roll and a wet plating bath.
[FIG. 5] FIG. 5 is an explanatory diagram illustrating a component of a long insertion sheet having transferred onto a surface of a metal seed layer on a long resin film.

### MODES FOR PRACTICING THE INVENTION

Metal film-coated resin film manufacturing apparatuses according to embodiments of the present invention are described below in detail, and sputtering web coaters (vacuum deposition apparatuses) for depositing a metal seed layer are specifically described as well.

### 1. Sputtering Web Coater (Vacuum Deposition Apparatus) for Depositing Metal Seed Layer on One Surface

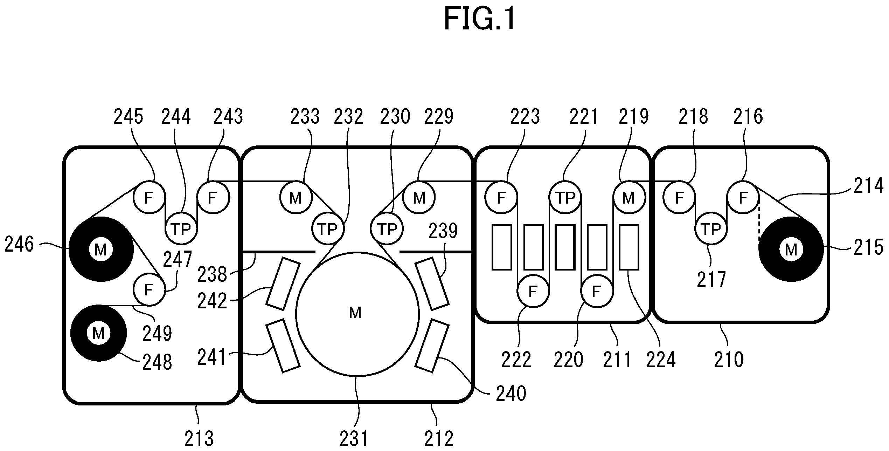

Firstly, a sputtering web coater (vacuum deposition apparatus) for depositing a metal seed layer on one surface is specifically described with reference to FIG. 1.

In FIG. 1, motor driven rolls are denoted by reference sign M (motor), tension measurement rolls are denoted by reference sign TP (tension pick up), and free rolls are denoted by reference sign F (free).

This sputtering web coater (vacuum deposition apparatus) includes an unwinding chamber 210, a drying chamber 211, a deposition chamber 212, and a winding chamber 213. Meanwhile, a "surface treatment chamber" in which plasma irradiation or ion beam irradiation is performed to improve the bond between a film and a metal film is provided in some cases between the drying chamber 211 and the deposition chamber 212.

In the unwinding chamber 210, an unwinding roll 215 is disposed around which is wound a long resin film 214 with no film deposited thereon or with a metal seed layer deposited on one surface, and the unwinding chamber 210 is configured such that the long resin film 214 unwound from the unwinding roll 215 is transferred to the drying chamber 211 through a free roll 216, a tension measurement roll 217, and a free roll 218. Note that the unwinding chamber 210 is configured such that the tension of the film for the unwinding is measured by the tension measurement roll 217 and fed back to and controlled by the unwinding roll 215.

In the drying chamber 211, film drying heaters 224 are disposed, and the drying chamber 211 is configured such that the long resin film 214 transferred from the unwinding chamber 210 is transferred to the deposition chamber 212 through a driven roll 219, a free roll 220, a tension measurement roll 221, a free roll 222, and a free roll 223 while undergoing a drying process. Note that the drying chamber 211 is configured such that the tension of the film for the drying is measured by the tension measurement roll 221 and fed back to and controlled by the driven roll 219.

In the deposition chamber 212, sputtering cathodes 239, 240, 241, and 242 are disposed, and the deposition chamber 212 is configured such that the long resin film 214 transferred from the drying chamber 211 is transferred to the winding chamber 213 through a driven roll 229, a tension measurement roll 230, a can roll 231, a tension measurement roll 232, and a driven roll 233 while a metal seed layer is deposited on one surface of the long resin film 214. Also, the deposition chamber 212 is configured such that the tension of the film upstream of the can roll 231 is measured by the tension measurement roll 230 and fed back to and controlled by the driven roll 229, and the tension of the film downstream of the can roll is measured by the tension measurement roll 232 and fed back to and controlled by the driven roll 233. Note that reference sign 238 in FIG. 1 denotes a shield plate configured to prevent sputtering particles ejected from the target of each sputtering cathode from traveling to, for example, the drying chamber 211 or the winding chamber 213 as a result of deviating from a predetermined travel path.

In the winding chamber 213, a winding roll 246 and a long insertion sheet unwinding roll 248 are disposed, and the winding chamber 213 is configured such that the long resin film 214 with the metal seed layer transferred from the deposition chamber 212 is wound up around the winding roll 246 through a free roll 243, a tension measurement roll 244, and a free roll 245 while a long insertion sheet 249 unwound from the long insertion sheet unwinding roll 248 is inserted between layers of the film through a free roll 247. Note that the winding chamber 213 is configured such that the tension of the film for the winding is measured by the tension measurement roll 244 and fed back to and controlled by the winding roll 246.

Thus, the long resin film 214 having passed through the unwinding chamber 210, the drying chamber 211, and the deposition chamber 212 and thus having the metal seed layer deposited thereon is wound up around the winding roll 246 in the winding chamber 213 while the long insertion sheet 249 is inserted between layers of the film. Meanwhile, to deposit a metal seed layer on both surfaces of the long resin film 214 by using this sputtering web coater (vacuum deposition apparatus), the long resin film 214 after being wound up around the winding roll 246 with a metal seed layer deposited on one surface is taken out and then again the long resin film 214 with a metal seed layer already deposited on the one surface is set on the unwinding roll 215 and passed through the unwinding chamber 210, the drying chamber 211, and the deposition chamber 212 to deposit a metal seed layer on the other surface of the long resin film 214. In this case, the film passage route from the unwinding roll 215 is the broken line illustrated in the unwinding chamber 210.

Meanwhile, if the long resin film 214 with a metal seed layer deposited on the other surface is directly wound up around the winding roll 246, a blocking phenomenon occurs in which the metal seed layers deposited on the one surface side and the other surface side strongly contact each other in vacuo and get attached to each other. To prevent this blocking phenomenon, as in the case of depositing a metal seed layer on the one surface side, the long resin film 214 may be wound up around the winding roll 246 in the winding chamber 213 while the long insertion sheet 249 unwound from the long insertion sheet unwinding roll 248 is inserted between layers of the film. Note that FIG. 1 illustrates only the minimum required rolls for describing the sputtering web coater (vacuum deposition apparatus), and there are also rolls that are not illustrated.

Further, the vacuum chambers constructed as the unwinding chamber 210, the drying chamber 211, the deposition chamber 212, and the winding chamber 213 each include evacuation equipment. In particular, in the deposition chamber 212, for the sputtering deposition, the pressure is lowered to about an ultimate pressure of 10⁻⁴ Pa and thereafter the pressure is adjusted to about 0.1 to 10 Pa via introduction of a sputtering gas. A publicly known gas such as argon is used as the sputtering gas and, depending on the purpose, a gas such as oxygen is further added. The shape and material of each vacuum chamber are not particularly limited but various shapes and materials are usable as long as they can withstand the above depressurized state. The vacuum chamber is equipped with various apparatuses not illustrated such as dry pumps, turbomolecular pumps, and cryocoils to depressurize the inside of the vacuum chamber and maintain that state.

Meanwhile, for sputtering deposition of the metal seed layer, plate-shaped targets are used, as illustrated in FIG. 1. However, in the case of using plate-shaped targets, generation of nodules (growth of foreign matter) may occur on the targets in some cases. If this is problematic, it is preferable to use cylindrical rotary targets, which are free from the generation of nodules and also have high target use efficiency.

Also, magnetron sputtering cathodes are illustrated in the sputtering web coater (vacuum deposition apparatus) in FIG. 1. However, in a case of using a different vacuum deposition apparatus for chemical vapor deposition (CVD), a vapor deposition process, or the like, different vacuum deposition means is incorporated in place of the plate-shaped targets.

### 2. Sputtering Web Coater (Vacuum Deposition Apparatus) for Depositing Metal Seed Layer on Both Surfaces

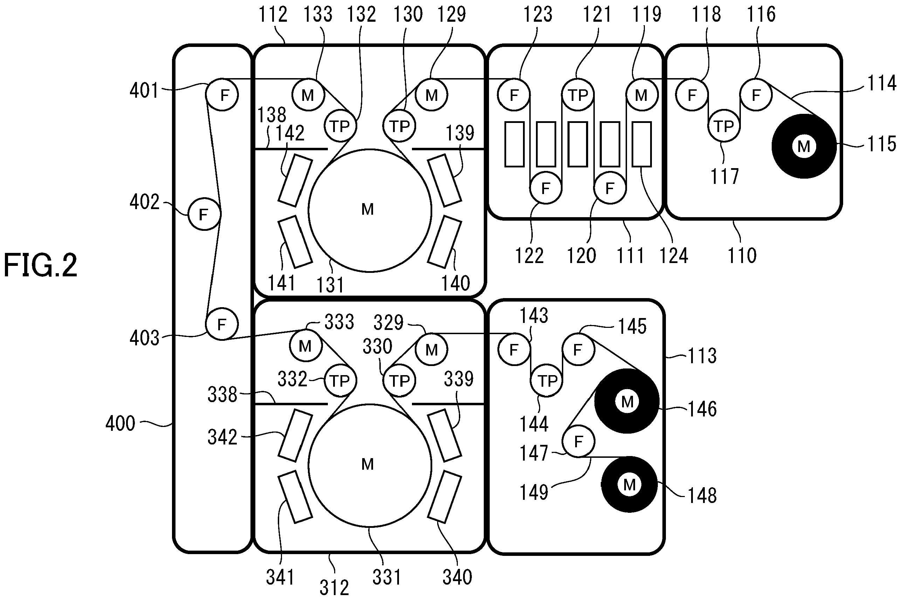

Next, a sputtering web coater (vacuum deposition apparatus) for depositing a metal seed layer on both surfaces is specifically described with reference to FIG. 2.

In FIG. 2, motor driven rolls are denoted by reference sign M (motor), tension measurement rolls are denoted by reference sign TP (tension pick up), and free rolls are denoted by reference sign F (free).

As illustrated in FIG. 2, this sputtering web coater (vacuum deposition apparatus) includes an unwinding chamber 110, a drying chamber 111, a deposition chamber 112, a transfer chamber 400, a deposition chamber 312, and a winding chamber 113. Meanwhile, a "surface treatment chamber" in which plasma irradiation or ion beam irradiation is performed to improve the bond between a film and a metal film is provided in some cases between the drying chamber 111 and the deposition chamber 112.

In the unwinding chamber 110, an unwinding roll 115 is disposed around which is wound a long resin film 114 with no film deposited thereon, and the unwinding chamber 110 is configured such that the long resin film 114 unwound from the unwinding roll 115 is transferred to the drying chamber 111 through a free roll 116, a tension measurement roll 117, and a free roll 118. Note that the unwinding chamber 110 is configured such that the tension of the film for the unwinding is measured by the tension measurement roll 117 and fed back to and controlled by the unwinding roll 115.

In the drying chamber 111, film drying heaters 124 are disposed, and the drying chamber 111 is configured such that the long resin film 114 with no film deposited thereon transferred from the unwinding chamber 110 is transferred to the deposition chamber 112 through a driven roll 119, a free roll 120, a tension measurement roll 121, a free roll 122, and a free roll 123 while undergoing a drying process. Note that the drying chamber 111 is configured such that the tension of the film for the drying is measured by the tension measurement roll 121 and fed back to and controlled by the driven roll 119.

In the deposition chamber 112, sputtering cathodes 139, 140, 141, and 142 are disposed, and the deposition chamber 112 is configured such that the long resin film 114 with no film deposited thereon transferred from the drying chamber 111 is transferred to the transfer chamber 400 through a driven roll 129, a tension measurement roll 130, a can roll 131, a tension measurement roll 132, and a driven roll 133 while a metal seed layer is deposited on one surface of the long resin film 114. Also, the deposition chamber 112 is configured such that the tension of the film upstream of the can roll 131 is measured by the tension measurement roll 130 and fed back to and controlled by the driven roll 129, and the tension of the film downstream of the can roll is measured by the tension measurement roll 132 and fed back to and controlled by the driven roll 133. Note that reference sign 138 in FIG. 2 denotes a shield plate.

Also, in the transfer chamber 400, free rolls 401, 402, and 403 are disposed, and the transfer chamber 400 is configured such that the long resin film 114 with the metal seed layer on the one surface transferred from the deposition chamber 112 is transferred to the deposition chamber 312 through the free rolls 401, 402, and 403. Note that by passing through the transfer chamber 400, the long resin film 114 is adjusted such that the surface side of the long resin film 114 with no film deposited thereon will be exposed to the sputtering cathode side in the deposition chamber 312 at the next stage and a film will be deposited on this other surface side.

In the deposition chamber 312, sputtering cathodes 339, 340, 341, and 342 are disposed, and the deposition chamber 312 is configured such that the long resin film 114 transferred from the transfer chamber 400 is transferred to the winding chamber 113 through a driven roll 333, a tension measurement roll 332, a can roll 331, a tension measurement roll 330, and a driven roll 329 while a metal seed layer is deposited on the other surface of the long resin film 114. Also, the deposition chamber 312 is configured such that the tension of the film upstream of the can roll 331 is measured by the tension measurement roll 332 and fed back to and controlled by the driven roll 333, and the tension of the film downstream of the can roll is measured by the tension measurement roll 330 and fed back to and controlled by the driven roll 329. Note that reference sign 338 in FIG. 2 denotes a shield plate.

In the winding chamber 113, a winding roll 146 and a long insertion sheet unwinding roll 148 are disposed, and the winding chamber 113 is configured such that the long resin film 114 with the metal seed layers on both surfaces transferred from the deposition chamber 312 is wound up around the winding roll 146 through a free roll 143, a tension measurement roll 144, and a free roll 145 while a long insertion sheet 149 unwound from the long insertion sheet unwinding roll 148 is inserted between layers of the film through a free roll 147. Note that the winding chamber 113 is configured such that the tension of the film for the winding is measured by the tension measurement roll 144 and fed back to and controlled by the winding roll 146.

Thus, the long resin film 114 having passed through the unwinding chamber 110, the drying chamber 111, the deposition chamber 112, the transfer chamber 400, and the deposition chamber 312 and thus having the metal seed layers deposited on both surfaces is wound up around the winding roll 146 in the winding chamber 113 while the long insertion sheet 149 is inserted between layers of the film.

Meanwhile, if the long resin film 114 with the metal seed layers deposited on both surfaces is directly wound up around the winding roll 146, a blocking phenomenon occurs in which the metal seed layers deposited on the one surface side and the other surface side strongly contact each other in vacuo and get attached to each other. To prevent this blocking phenomenon, the long resin film 114 may be wound up around the winding roll 146 while the long insertion sheet 149 unwound from the long insertion sheet unwinding roll 148 is inserted between layers of the film, as described above. Note that FIG. 2 illustrates only the minimum required rolls for describing the sputtering web coater (vacuum deposition apparatus), and there are also rolls that are not illustrated.

Further, the vacuum chambers constructed as the unwinding chamber 110, the drying chamber 111, the deposition chamber 112, the transfer chamber 400, the deposition chamber 312, and the winding chamber 113 each include evacuation equipment. In particular, in the deposition chambers 112 and 312, for the sputtering deposition, the pressure is lowered to about an ultimate pressure of 10⁻⁴ Pa and thereafter the pressure is adjusted to about 0.1 to 10 Pa via introduction of a sputtering gas. A publicly known gas such as argon is used as the sputtering gas and, depending on the purpose, a gas such as oxygen is further added. The shape and material of each vacuum chamber are not particularly limited but various shapes and materials are usable as long as they can withstand the above depressurized state. The vacuum chamber is equipped with various apparatuses not illustrated such as dry pumps, turbomolecular pumps, and cryocoils to depressurize the inside of the vacuum chamber and maintain that state.

Meanwhile, for sputtering deposition of each metal seed layer, plate-shaped targets are used, as illustrated in FIG. 2. However, in the case of using plate-shaped targets, generation of nodules (growth of foreign matter) may occur on the targets in some cases. If this is problematic, it is preferable to use cylindrical rotary targets, which are free from the generation of nodules and also have high target use efficiency.

Also, magnetron sputtering cathodes are illustrated in the sputtering web coater (vacuum deposition apparatus) in FIG. 2. However, in a case of using a different vacuum deposition apparatus for chemical vapor deposition (CVD), a vapor deposition process, or the like, different vacuum deposition means is incorporated in place of the plate-shaped targets.

### 3. Problems with Winding Up Long Resin Film with Long Insertion Sheet Inserted between Layers of Film

Examples of the long resin film employed in a metal film-coated resin film include a heat-resistant resin film selected from among a polyimide-based film, a polyamide-based film, a polyester-based film, a polytetrafluoroethylene-based film, a polyphenylene sulfide-based film, a polyethylene naphthalate-based film, and a liquid crystal polymer-based film, and the like. Metal film-coated resin films obtained by using these resin films are superior in flexibility required for the above-mentioned flexible wiring substrates, strength necessary for practical use, and electrical insulation performance suitable for wiring materials.

On the other hand, as the long insertion sheet to be inserted between layers of the long resin film with a metal seed layer deposited on one or both surfaces, used is also a resin film selected from among a polyimide-based film, a polyamide-based film, a polyester-based film, a polytetrafluoroethylene-based film, a polyphenylene sulfide-based film, a polyethylene naphthalate-based film, and a liquid crystal polymer-based film, or the like. Specific examples include polyethylene, polypropylene, polyethylene terephthalate, polyethylene naphthalate, polystyrene, polyvinyl alcohol, polycarbonate, polyphenylene sulfide, polyether ether ketone, polyethersulfone, aramid, polyimide, and triacetate alone and composites of any of these laminated to each other.

Meanwhile, if a long resin film with a metal seed layer deposited on both surfaces is wound up in a roll form without air interposed in a vacuum deposition apparatus such as a sputtering web coater, there is a problem in that a blocking phenomenon in which the metal seed layers get attached to each other occurs and the surface of either metal seed layer is locally torn off when the long resin film is unwound from a roll. To avoid this problem, the above-mentioned long insertion sheet is utilized. However, in the case where the long resin film is wound up while the long insertion sheet is inserted between layers of the long resin film, the long insertion sheet contacts the surfaces of the metal seed layers immediately after being deposited. Consequently, a component of the long insertion sheet (e.g., any of the above-listed resin film components, a solvent component contained in the resin film, or the like) may locally transfer onto the surfaces of the metal seed layers. This leads to a new problem confirmed such that, if the long resin film with the component of the long insertion sheet having locally transferred onto the surfaces of the metal seed layers is unwound from the roll and undergoes wet plating, defects such as pinholes are formed in the metal films due to the component having transferred onto the surfaces of the metal seed layers.

To address this problem, a method has been considered in which the surfaces of the metal seed layers undergo acid cleaning with a diluted sulfuric acid solution or the like after the long resin film with the above component having locally transferred onto the surfaces of the metal seed layers is unwound from the roll but before the long resin film is transferred into the wet plating bath. However, it is difficult to completely remove the component of the long insertion sheet having transferred onto the surfaces of the metal seed layers with a diluted sulfuric acid solution or the like, and it is therefore difficult to completely eliminate the formation of pinholes or the like.

The metal film-coated resin film manufacturing apparatuses according to the embodiments provide a metal film-coated resin film without pinholes or the like by performing atmospheric-pressure plasma cleaning on the surface of a metal seed layer deposited on a long resin film before the long resin film with the metal seed layer is transferred into a wet plating bath.

### 4. Metal Film-Coated Resin Film Manufacturing Apparatus According to First Embodiment

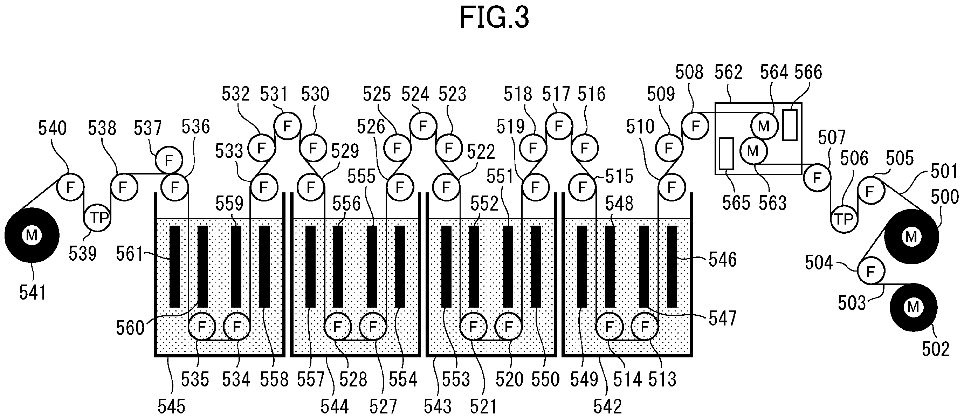

A metal film-coated resin film manufacturing apparatus according to a first embodiment is characterized by incorporating an "atmospheric-pressure plasma cleaning apparatus" configured to irradiate a long resin film transferred on cooling rolls as illustrated in FIG. 3 with an atmospheric-pressure plasma.

Note that, as in the case of the sputtering web coaters (vacuum deposition apparatuses), only the minimum required rolls for describing the metal film-coated resin film manufacturing apparatus are illustrated. Also, motor driven rolls are denoted by reference sign M (motor), tension measurement rolls are denoted by reference sign TP (tension pick up), and free rolls are denoted by reference sign F (free).

As illustrated in FIG. 3, the metal film-coated resin film manufacturing apparatus according to the first embodiment includes: a long resin film unwinding roll 500 around which is wound a long resin film 501 with a metal seed layer deposited thereon; an "atmospheric-pressure plasma cleaning apparatus" which cleans the surface of the metal seed layer on the long resin film 501 unwound from the long resin film unwinding roll 500; a "wet plating apparatus" which forms a metal film on the metal seed layer on the long resin film 501 transferred out of the "atmospheric-pressure plasma cleaning apparatus"; and a long resin film winding roll 541 which winds up the long resin film 501 transferred out of the "wet plating apparatus".

The long resin film 501 with the metal seed layer deposited thereon is wound up around the long resin film unwinding roll 500 with a long insertion sheet 503 inserted between layers of the long resin film 501. When the long resin film 501 is unwound from the long resin film unwinding roll 500, the long insertion sheet 503 is separated and this long insertion sheet 503 is collected by a long insertion sheet winding roll 502 through a free roll 504. Meanwhile, as for the tension of the long insertion sheet for the winding, a tension measurement roll may be disposed at an intermediate position and the tension may be fed back to the long insertion sheet winding roll 502 and its motor torque may be controlled accordingly, or the tension may be calculated using a torque meter attached to the motor and an encoder signal.

The long resin film 501 unwound from the long resin film unwinding roll 500 is transferred into a plasma processing box 562 in the "atmospheric-pressure plasma cleaning apparatus" through a free roll 505, a tension measurement roll 506, and a free roll 507.

The configuration is such that inside the plasma processing box 562 in the "atmospheric-pressure plasma cleaning apparatus", atmospheric-pressure plasma heads 565 and 566 irradiate the long resin film 501 transferred on water-cooled motor driven rolls (cooling rolls) 563 and 564 with an atmospheric-pressure plasma. Depending on the gas used and the condition, the atmospheric-pressure plasma processing generates a large amount of ozone and therefore requires evacuation. Also, depending on the gas used and the condition, the atmospheric-pressure plasma processing may heat the long resin film to high temperature. For this reason, it is desirable to irradiate the long resin film 501 transferred on the water-cooled motor driven rolls (cooling rolls) 563 and 564. The atmospheric-pressure plasma heads 565 and 566 are disposed to face the water-cooled motor driven rolls (cooling rolls) 563 and 564 so that both surfaces of the long resin film 501 can be processed.

The long resin film 501 transferred out of the "atmospheric-pressure plasma cleaning apparatus" is transferred to the "wet plating apparatus", which has wet plating baths 542, 543, 544, and 545.

Specifically, the long resin film 501 transferred out of the plasma processing box 562 in the "atmospheric-pressure plasma cleaning apparatus" is transferred into the wet plating bath 542 through a free roll 508 and power feed rolls 509 and 510 provided for both surfaces. After being transferred out of the wet plating bath 542 through free rolls 513 and 514 in the wet plating bath 542, the long resin film 501 passes power feed rolls 515 and 516 and is then transferred into the wet plating bath 543 through a free roll 517 and power feed rolls 518 and 519 provided for both surfaces.

Thereafter, the long resin film 501 transferred into the wet plating bath 543 is transferred out of the wet plating bath 543 through free rolls 520 and 521 in the wet plating bath 543. After this, the long resin film 501 passes power feed rolls 522 and 523 and is then transferred into the wet plating bath 544 through a free roll 524 and power feed rolls 525 and 526 provided for both surfaces.

Thereafter, the long resin film 501 transferred into the wet plating bath 544 is transferred out of the wet plating bath 544 through free rolls 527 and 528 in the wet plating bath 544. After this, the long resin film 501 passes power feed rolls 529 and 530 and is then transferred into the wet plating bath 545 through a free roll 531 and power feed rolls 532 and 533 provided for both surfaces.

Subsequently, the long resin film 501 transferred into the wet plating bath 545 is transferred out of the wet plating bath 545 through free rolls 534 and 535 in the wet plating bath 545, and then passes power feed rolls 536 and 537 and is transferred out of the "wet plating apparatus".

Meanwhile, in the metal film-coated resin film manufacturing apparatus according to the first embodiment, the "wet plating apparatus" includes the four wet plating baths 542, 543, 544, and 545. However, the number of wet plating baths is not limited to four, and the "wet plating apparatus" may include four or less wet plating baths or four or more wet plating baths. Also, in FIG. 3, illustration of water washing baths and pumps and the like necessary for circulation in the plating baths is omitted.

Also, inside the wet plating baths 542, 543, 544, and 545 forming the "wet plating apparatus", anodes 546, 547, 548, 549, 550, 551, 552, 553, 554, 555, 556, 557, 558, 559, 560, and 561 are disposed which are provided for both surfaces of the long resin film 501 transferred into the wet plating baths. Also, the power feed rolls for the surfaces of the long resin film 501 to be cathodes in the wet plating baths 542, 543, 544, and 545 and the anodes are paired and connected to respective plating power supplies (rectifiers). Meanwhile, copper sulfate plating baths are used as the wet plating baths 542, 543, 544, and 545.

The configuration is such that the long resin film 501 transferred out of the "wet plating apparatus" is next wound up by the long resin film winding roll 541 through a free roll 538, a tension measurement roll 539, and a free roll 540. Note that the configuration is such that the tension of the film for the winding is measured by the tension measurement roll 539 and fed back to and controlled by the long resin film winding roll 541.

In the metal film-coated resin film manufacturing apparatus according to the first embodiment, the "atmospheric-pressure plasma cleaning apparatus", which cleans the surface of the metal seed layer on the long resin film 501 from which the long insertion sheet 503 has been separated, is provided between the long resin film unwinding roll 500 and the "wet plating apparatus". Thus, the transferred component of the long insertion sheet 503 can be removed from the surface of the metal seed layer before the long resin film 501 is transferred into the wet plating bath 542 in the "wet plating apparatus". This enables high-yield manufacturing of a high-quality metal film-coated resin film that is less prone to formation of defects such as pinholes in its metal film formed by the "wet plating apparatus".

### 5. Metal Film-Coated Resin Film Manufacturing Apparatus According to Second Embodiment

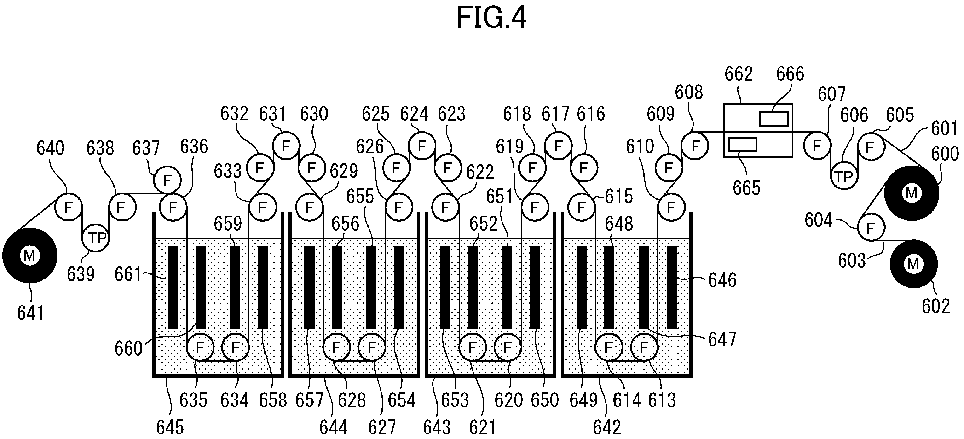

A metal film-coated resin film manufacturing apparatus according to a second embodiment is characterized by incorporating an "atmospheric-pressure plasma cleaning apparatus" configured to irradiate a long resin film transferred in a floating state as illustrated in FIG. 4 with an atmospheric-pressure plasma.

Note that, as in the case of the sputtering web coaters (vacuum deposition apparatuses), only the minimum required rolls for describing the metal film-coated resin film manufacturing apparatus are illustrated. Also, motor driven rolls are denoted by reference sign M (motor), tension measurement rolls are denoted by reference sign TP (tension pick up), and free rolls are denoted by reference sign F (free).

As illustrated in FIG. 4, the metal film-coated resin film manufacturing apparatus according to the second embodiment includes: a long resin film unwinding roll 600 around which is wound a long resin film 601 with a metal seed layer deposited thereon; an "atmospheric-pressure plasma cleaning apparatus" which cleans the surface of the metal seed layer on the long resin film 601 unwound from the long resin film unwinding roll 600; a "wet plating apparatus" which forms a metal film on the metal seed layer on the long resin film 601 transferred out of the "atmospheric-pressure plasma cleaning apparatus"; and a long resin film winding roll 641 which winds up the long resin film 601 transferred out of the "wet plating apparatus".

The long resin film 601 with the metal seed layer deposited thereon is wound up around the long resin film unwinding roll 600 with a long insertion sheet 603 inserted between layers of the long resin film 601. When the long resin film 601 is unwound from the long resin film unwinding roll 600, the long insertion sheet 603 is separated and this long insertion sheet 603 is collected by a long insertion sheet winding roll 602 through a free roll 604. Meanwhile, as for the tension of the long insertion sheet for the winding, a tension measurement roll may be disposed at an intermediate position and the tension may be fed back to the long insertion sheet winding roll 602 and its motor torque may be controlled accordingly, or the tension may be calculated using a torque meter attached to the motor and an encoder signal.

The long resin film 601 unwound from the long resin film unwinding roll 600 is transferred into a plasma processing box 662 in the "atmospheric-pressure plasma cleaning apparatus" through a free roll 605, a tension measurement roll 606, and a free roll 607.

The configuration is such that inside the plasma processing box 662 in the "atmospheric-pressure plasma cleaning apparatus", atmospheric-pressure plasma heads 665 and 666 irradiate the long resin film 601 transferred in the floating state with an atmospheric-pressure plasma. Depending on the gas used and the condition, the atmospheric-pressure plasma processing generates a large amount of ozone and therefore requires evacuation. Also, depending on the gas used and the condition, the atmospheric-pressure plasma processing may heat the long resin film to high temperature. For this reason, the metal film-coated resin film manufacturing apparatus according to the first embodiment has a structure in which the long resin film transferred on the above-mentioned water-cooled motor driven rolls (cooling rolls) 563 and 564 is irradiated with an atmospheric-pressure plasma. In some cases, however, depending on the gas used and the condition, the atmospheric-pressure plasma process does not necessarily heat the long resin film to high temperature and therefore does not requiring the cooling on the water-cooled motor driven rolls (cooling rolls) 563 and 564. Thus, the atmospheric-pressure plasma heads 665 and 666 are disposed to face the long resin film 601 transferred in the floating state through the plasma processing box 662 such that both surfaces of the long resin film 601 can be processed.

The long resin film 601 transferred out of the "atmospheric-pressure plasma cleaning apparatus" is transferred to the "wet plating apparatus", which has wet plating baths 642, 643, 644, and 645.

Specifically, the long resin film 601 transferred out of the plasma processing box 662 in the "atmospheric-pressure plasma cleaning apparatus" is transferred into the wet plating bath 642 through a free roll 608 and power feed rolls 609 and 610 provided for both surfaces. After being transferred out of the wet plating bath 642 through free rolls 613 and 614 in the wet plating bath 642, the long resin film 601 passes power feed rolls 615 and 616 and is then transferred into the wet plating bath 643 through a free roll 617 and power feed rolls 618 and 619 provided for both surfaces.

Thereafter, the long resin film 601 transferred into the wet plating bath 643 is transferred out of the wet plating bath 643 through free rolls 620 and 621 in the wet plating bath 643. After this, the long resin film 601 passes power feed rolls 622 and 623 and is then transferred into the wet plating bath 644 through a free roll 624 and power feed rolls 625 and 626 provided for both surfaces.

Thereafter, the long resin film 601 transferred into the wet plating bath 644 is transferred out of the wet plating bath 644 through free rolls 627 and 628 in the wet plating bath 644. After this, the long resin film 601 passes power feed rolls 629 and 630 and is then transferred into the wet plating bath 645 through a free roll 631 and power feed rolls 632 and 633 provided for both surfaces.

Subsequently, the long resin film 601 transferred into the wet plating bath 645 is transferred out of the wet plating bath 645 through free rolls 634 and 635 in the wet plating bath 645, and then passes power feed rolls 636 and 637 and is transferred out of the "wet plating apparatus".

Meanwhile, in the metal film-coated resin film manufacturing apparatus according to the second embodiment too, the "wet plating apparatus" includes the four wet plating baths 642, 643, 644, and 645. However, the number of wet plating baths is not limited to four, and the "wet plating apparatus" may include four or less wet plating baths or four or more wet plating baths. Also, in FIG. 4, illustration of water washing baths and pumps and the like necessary for circulation in the plating baths is omitted.

Also, inside the wet plating baths 642, 643, 644, and 645 forming the "wet plating apparatus", anodes 646, 647, 648, 649, 650, 651, 652, 653, 654, 655, 656, 657, 658, 659, 660, and 661 are disposed which are provided for both surfaces of the long resin film 601 transferred into the wet plating baths. Also, the power feed rolls for the surfaces of the long resin film 601 to be cathodes in the wet plating baths 642, 643, 644, and 645 and the anodes are paired and connected to respective plating power supplies (rectifiers). Meanwhile, copper sulfate plating baths are used as the wet plating baths 642, 643, 644, and 645.

The configuration is such that the long resin film 601 transferred out of the "wet plating apparatus" is next wound up by the long resin film winding roll 641 through a free roll 638, a tension measurement roll 639, and a free roll 640. Note that the configuration is such that the tension of the film for the winding is measured by the tension measurement roll 639 and fed back to and controlled by the long resin film winding roll 641.

In the metal film-coated resin film manufacturing apparatus according to the second embodiment too, the "atmospheric-pressure plasma cleaning apparatus", which cleans the surface of the metal seed layer on the long resin film 601 from which the long insertion sheet 603 has been separated, is provided between the long resin film unwinding roll 600 and the "wet plating apparatus". Thus, the transferred component of the long insertion sheet 603 can be removed from the surface of the metal seed layer before the long resin film 601 is transferred into the wet plating bath 642 in the "wet plating apparatus". This enables high-yield manufacturing of a high-quality metal film-coated resin film that is less prone to formation of defects such as pinholes in its metal film formed by the "wet plating apparatus".

### 6. Atmospheric-Pressure Plasma Apparatus

An atmospheric-pressure plasma apparatus is an apparatus capable of irradiating a resin film with a plasma without requiring vacuum equipment, and is used for the purpose of modifying the surface of a resin film, roughening the surface, and so on. As for the type of its power supply, there are an intermediate frequency (MHz) type, a high frequency (MHz) type, and a microwave frequency (GHz) type, as with vacuum plasma apparatuses. The effect is expected to be such that the higher the frequency is, the less rougher and the more uniform the surface becomes. As the base of the plasma gas, nitrogen, argon, air, or the like is employed and a trace amount of an additive gas is mixed according to the purpose.

The present inventor has discovered that, when a long resin film with a metal seed layer deposited thereon by using a vacuum deposition apparatus such as a sputtering web coater is strongly wound up in a roll form in vacuo while a blocking prevention long insertion sheet is inserted between layers of the long resin film, a component of the long insertion sheet locally transfers onto the surface of the metal seed layer. In addition, the present inventor has confirmed a problem in that this transferred component causes pinholes in a metal film formed by a wet plating method, and has further found that this problem can be solved by utilizing the above atmospheric-pressure plasma apparatus as the "atmospheric-pressure plasma cleaning apparatus".

Note that in consideration of the ease of operation to form a metal film on the metal seed layer continuously by the wet plating method, it is desirable to configure the above "atmospheric-pressure plasma cleaning apparatus" a remotely operated-type atmospheric-pressure plasma apparatus. Also, as for the metal seed layer deposited on one or both surfaces of the long resin film, it is preferable to set its film thickness within the range of 50 nm to 500 nm in consideration of the fact that the atmospheric-pressure plasma cleaning is performed on the surface of the metal seed layer.

### EXAMPLES

Examples of the present invention are specifically described below.

Note that the sputtering web coater in FIG. 2, which deposits a metal seed layer on both surfaces of a long resin film, is employed as the vacuum deposition apparatus used in Examples, and the metal film-coated resin film manufacturing apparatus according to the second embodiment illustrated in FIG. 4 is employed as the metal film-coated resin film manufacturing apparatus that performs wet plating on the metal seed layer with a metal film.

### [Deposition of Metal Seed Layer]

A metal seed layer was deposited on both surfaces of a long resin film by using the sputtering web coater illustrated in FIG. 2. As the long resin film 114 illustrated in FIG. 2, a heat-resistant polyimide film "UPILEX (registered trademark)", manufactured by Ube Industries, Ltd, measuring 600 mm in width, 1000 m in length, and 25 µm in thickness was used.

The metal seed layers deposited on both surfaces (first surface and second surface) of the long resin film 114 were each obtained by depositing a Ni-Cr film as a first layer and a Cu film as a second layer thereon. Thus, a Ni-Cr target was used as the target of the magnetron sputtering cathode 139 provided in the deposition chamber 112, which deposits a metal seed layer on the first surface of the long resin film 114, and Cu targets were used as the targets of the magnetron sputtering cathodes 140, 141, and 142 provided in the deposition chamber 112. Also, a Ni-Cr target was used as the target of the magnetron sputtering cathode 342 provided in the deposition chamber 312, which deposits a metal seed layer on the second surface of the long resin film 114, and Cu targets were used as the targets of the magnetron sputtering cathodes 341, 340, and 339 provided in the deposition chamber 312.

Then, in this state, the air in the deposition chamber 112 and the deposition chamber 312 was evacuated to 5 Pa by using a plurality of dry pumps and evacuated further to 3 × 10⁻³ Pa by using a plurality of turbomolecular pumps and cryocoils.

Subsequently, the sputtering web coater's rotational drive apparatus was actuated to transfer the long resin film 114 at a transfer speed of 5 m/min while an argon gas was introduced at 300 sccm, and also an electric power of 20 kW was applied to the magnetron sputtering cathodes with the Ni-Cr targets and an electric power of 30 kW was applied to the magnetron sputtering cathodes with the Cu targets. As a result, a 25-nm-thick Ni-Cr film and a 100-nm-thick Cu film were deposited as the first layer and the second layer, respectively.

Then, the long resin film 114 with the metal seed layers deposited on both surfaces was transferred into the winding chamber 113, and the long resin film 114 was wound up around the winding roll 146 while the long insertion sheet 149 was inserted between layers of the long resin film 114 in order to avoid the occurrence of the blocking.

Note that a 10-µm-thick PET film was used as the long insertion sheet 149, but a polypropylene (PP) film may be used instead.

### [Formation of Metal Film]

The long resin film on both surfaces of which the metal seed layers, each including the Ni-Cr layer and the Cu layer, were deposited and which was wound up while the blocking prevention long insertion sheet was inserted between layers of the film was unwound from the long resin film unwinding roll 600 of the metal film-coated resin film manufacturing apparatus according to the second embodiment while the long insertion sheet 603 was separated. Before the long resin film 601 was transferred into the "wet plating apparatus", the surfaces of the metal seed layers were cleaned by the "atmospheric-pressure plasma cleaning apparatus" to remove the component of the long insertion sheet 603 having transferred onto the surfaces of the metal seed layers. Thereafter, the long resin film 601 was transferred into the "wet plating apparatus" at a transfer speed of 3 m/min to plate the metal seed layers with a 1-um-thick Cu layer.

Note that a remote-type intermediate frequency (40 kHz) plasma apparatus using a plasma gas being a nitrogen gas with a trace amount of oxygen mixed therein was used as the "atmospheric-pressure plasma cleaning apparatus". 500 V was applied to each of the atmospheric-pressure plasma heads 665 and 666 disposed to face the long resin film 601 transferred in the floating state through the plasma processing box 662 from a plasma power supply not illustrated.

### [Evaluation Method]

It has been confirmed from observations with an electron microscope that if the component 100 of the long insertion sheet (a resin film component, a solvent component contained in the resin film, or the like, as mentioned above) locally transfers onto the surface of the metal seed layer 101 on the long resin film as illustrated in FIG. 5, this portion will turn into a pinhole with a diameter of several µm after the wet plating. By applying this, the cleaning effect on the transferred component by the atmospheric-pressure plasma can be evaluated based on the number of pinholes.

Here, it is difficult to observe pinholes in the metal film-coated resin film with a metal film formed on both surfaces. The evaluation was therefore made by: firstly masking the metal film on one surface and removing the metal film on the opposite surface by etching; capturing an image of pinholes within a 5.6 mm × 4.2 mm-field of view with a transmission microscope; and counting pinholes measuring 3 um or larger in diameter by an image analysis.

Table 1 shows decreases in the number of pinholes based on the presence and absence (ON, OFF) of the atmospheric-pressure plasma from such an evaluation.

**Table 1**

| Plasma Gas | | Ar | | | Ar + O₂ | | |
|---|---|---|---|---|---|---|---|
| Transfer Speed (m/min) | | 3 | 5 | 10 | 3 | 5 | 10 |
| Number of Pinholes | Plasma ON | 2 | 3 | 9 | 3 | 1 | 8 |
| | Plasma OFF | 32 | 28 | 35 | 38 | 29 | 37 |

### [Observation]

From the results shown in Table 1, it is observed that the atmospheric-pressure plasma cleaning process can significantly reduce pinholes.

Also, the effect of the atmospheric-pressure plasma cleaning process is correlated to the transfer speed of the long resin film. The effect slightly decreases when the transfer speed is high. In such a case, another pair of atmospheric-pressure plasma heads may be added to the "atmospheric-pressure plasma cleaning apparatus".

### POSSIBILITY OF INDUSTRIAL APPLICATION

According to the present invention, a high-quality metal film-coated resin film without pinholes or the like in its metal film can be manufactured at a high yield. The present invention is therefore industrially applicable as a manufacturing apparatus for metal film-coated resin films for use as flexible wiring substrates in laptop computers, digital cameras, mobile phones, and so on.

### REFERENCE SIGNS LIST

100 component having transferred from long insertion sheet
101 metal seed layer
110, 210 unwinding chamber
111, 211 drying chamber
124, 224 heater unit
112, 212, 312 deposition chamber
400 transfer chamber
113, 213 winding chamber
114, 214 long resin film
501, 601 long resin film with metal seed layer deposited thereon
115, 215, 500, 600 long resin film unwinding roll
146, 246, 541, 641 long resin film winding roll
149, 249, 503, 603 long insertion sheet
148, 248 long insertion sheet unwinding roll
502, 602 long insertion sheet winding roll
131, 231, 331 can roll
138, 238, 338 shield plate
139, 140, 141, 142, 339, 340, 341, 342, 239, 240, 241,
242 sputtering cathode
116, 118, 120, 122, 123, 401, 402, 403, 143, 145, 147,
216, 218, 220, 222, 223, 243, 245, 247, 504, 505, 507,
508, 513, 514, 517, 520, 521, 524, 527, 528, 531, 534,
535, 538, 540, 604, 605, 607, 608, 613, 614, 617, 620,
621, 624, 627, 628, 631, 634, 635, 638, 640 free roll
117, 121, 130, 132, 332, 330, 144, 217, 221, 230, 232,
244, 506, 539, 606, 639 tension measurement roll
119, 129, 133, 333, 329, 219, 229, 233 motor driven roll
562, 662 plasma processing box
563, 564 water-cooled motor driven roll
565, 566, 665, 666 atmospheric-pressure plasma head
542, 543, 544, 545, 642, 643, 644, 645 wet plating bath
509, 510, 515, 516, 518, 519, 522, 523, 525, 526, 529,
530, 532, 533, 536, 537, 609, 610, 615, 616, 618, 619,
622, 623, 625, 626, 629, 630, 632, 633, 636, 637 power feed roll
546, 547, 548, 549, 550, 551, 552, 553, 554, 555, 556,
557, 558, 559, 560, 561, 646, 647, 648, 649, 650, 651,
652, 653, 654, 655, 656, 657, 658, 659, 660, 661 anode

## Claims

1. A metal film-coated resin film manufacturing apparatus comprising:
a long resin film unwinding roll (500, 600) around which a long resin film (501, 601) with a metal seed layer deposited on one or both surfaces thereof is wound up with a long insertion sheet (503,603) inserted between layers of the long resin film (501, 601) ;
a long insertion sheet winding roll (502, 602) which separates the long insertion sheet (503, 603) from the long resin film (501, 601) unwound from the long resin film unwinding roll (500, 600) and winds up the long insertion sheet (503, 603);
a wet plating bath (542, 543, 544, 545, 642, 643, 644, 645) into which the long resin film (501, 601) from which the long insertion sheet (503, 603) has been separated is transferred to form a metal film on the metal seed layer; and
a long resin film winding roll (541, 641) which winds up the long resin film (501, 601) with the metal film formed thereon,
**characterized in that** the apparatus comprises an atmospheric-pressure plasma cleaning apparatus which cleans a surface of the metal seed layer on the long resin film (501, 601) from which the long insertion sheet (503, 603) has been separated, the atmospheric-pressure plasma cleaning apparatus being provided between the long resin film unwinding roll (500, 600) and the wet plating bath (542, 642).

2. The metal film-coated resin film manufacturing apparatus according to claim 1, **characterized in that** the metal seed layer and the metal film on the long resin film (501, 601) contain Cu as a main component.

3. The metal film-coated resin film manufacturing apparatus according to claim 1, **characterized in that** the long insertion sheet (503, 603) is made of polyethylene, polypropylene, polyethylene terephthalate, polyethylene naphthalate, polystyrene, polyvinyl alcohol, polycarbonate, polyphenylene sulfide, polyether ether ketone, polyethersulfone, aramid, polyimide, or triacetate alone, or a composite of any of these laminated to each other.

4. The metal film-coated resin film manufacturing apparatus according to claim 1, **characterized in that** the atmospheric-pressure plasma cleaning apparatus is of a remotely operated type.

5. A metal film-coated resin film manufacturing method comprising the steps of:
unwinding a long resin film (501, 601) with a metal seed layer deposited on one or both surfaces thereof from a long resin film unwinding roll (500, 600) around which the long resin film (501, 601) is wound up with a long insertion sheet (503, 603) inserted between layers of the long resin film (501, 601) ;
separating the long insertion sheet (503, 603) from the long resin film (501, 601) unwound from the long resin film unwinding roll (500, 600) and winding up the long insertion sheet (503, 603) around a long insertion sheet winding roll (502, 602);
transferring the long resin film (501,601) from which the long insertion sheet (503, 603) has been separated into a wet plating bath (542, 543, 544, 545, 642, 643, 644, 645) to form a metal film on the metal seed layer; and
winding up the long resin film (501, 601) with the metal film formed thereon around a long resin film winding roll (541, 641),
**characterized in that** the method comprises performing atmospheric-pressure plasma cleaning on a surface of the metal seed layer on the long resin film (501, 601) from which the long insertion sheet (503, 603) has been separated, before the long resin film (501, 601) is transferred into the wet plating bath (542, 642).

6. The metal film-coated resin film manufacturing method according to claim 5, **characterized in that** the metal seed layer and the metal film on the long resin film (501, 601) contain Cu as a main component.

7. The metal film-coated resin film manufacturing method according to claim 5, **characterized in that** the long insertion sheet (503, 603) is made of polyethylene, polypropylene, polyethylene terephthalate, polyethylene naphthalate, polystyrene, polyvinyl alcohol, polycarbonate, polyphenylene sulfide, polyether ether ketone, polyethersulfone, aramid, polyimide, or triacetate alone, or a composite of any of these laminated to each other.

8. The metal film-coated resin film manufacturing method according to claim 5, **characterized in that** an apparatus which performs the atmospheric-pressure plasma cleaning on the surface of the metal seed layer on the long resin film (501, 601) is configured as a remotely operated-type apparatus.

## Patentansprüche

1. Vorrichtung zur Herstellung einer mit einem Metallfilm beschichteten Harzfolie, umfassend:
eine lange Harzfolie-Abwickelrolle (500, 600), um die eine lange Harzfolie (501, 601) mit einer auf einer oder beiden Oberflächen desselben abgeschiedenen Metallkeimschicht aufgewickelt wird, wobei ein langes Einführungsblatt (503, 603) zwischen Schichten der langen Harzfolie (501, 601) eingefügt ist;
eine lange Harzfolie-Wickelrolle (502, 602), die das lange Einführungsblatt (503, 603) von der langen Harzfolie (501, 601) trennt, der von der lange Harzfolie-Abwickelrolle (500, 600) abgewickelt wird, und das lange Einführungsblatt (503, 603) aufwickelt;
ein Nassplattierungsbad (542, 543, 544, 545, 642, 643, 644, 645), in das die lange Harzfolie (501, 601), von der das lange Einführungsblatt (503, 603) abgetrennt wurde, übertragen wird, um einen Metallfilm auf der Metallkeimschicht zu bilden; und
eine lange Harzfolie-Wickelrolle (541, 641), die die lange Harzfolie (501, 601) mit dem darauf gebildeten Metallfilm aufwickelt,
**dadurch gekennzeichnet, dass** die Vorrichtung eine Atmosphärendruck-Plasmareinigungsvorrichtung umfasst, die eine Oberfläche der Metallkeimschicht auf der langen Harzfolie (501, 601), von der das lange Einführungsblatt (503, 603) abgetrennt wurde, reinigt, wobei die Atmosphärendruck-Plasmareinigungsvorrichtung zwischen der lange Harzfolie-Abwickelrolle (500, 600) und dem Nassplattierungsbad (542, 642) bereitgestellt ist.

2. Vorrichtung zur Herstellung einer mit einem Metallfilm beschichteten Harzfolie nach Anspruch 1, **dadurch gekennzeichnet, dass** die Metallkeimschicht und der Metallfilm auf der langen Harzfolie (501, 601) Cu als Hauptbestandteil enthalten.

3. Vorrichtung zur Herstellung eines mit Metallfilm beschichteten Harzfilms nach Anspruch 1, **dadurch gekennzeichnet, dass** das lange Einführungsblatt (503, 603) aus Polyethylen, Polypropylen, Polyethylenterephthalat, Polyethylennaphthalat, Polystyrol, Polyvinylalkohol, Polycarbonat, Polyphenylensulfid, Polyetheretherketon, Polyethersulfon, Aramid, Polyimid oder Triacetat allein oder aus einem Verbundwerkstoff, bei dem welche davon miteinander laminiert sind, hergestellt ist.

4. Vorrichtung zur Herstellung von mit Metallfilm beschichteten Harzfilmen nach Anspruch 1, **dadurch gekennzeichnet, dass** die Atmosphärendruck-Plasmareinigungsvorrichtung vom ferngesteuerten Typ ist.

5. Verfahren zur Herstellung einer mit einem Metallfilm beschichteten Harzfolie, das die folgenden Schritte umfasst:
Abwickeln einer langen Harzfolie (501, 601) mit einer Metallkeimschicht, die auf einer oder beiden Oberflächen desselben abgeschieden ist, von einer lange Harzfolie-Abwickelrolle (500, 600), um die die lange Harzfolie (501, 601) aufgewickelt ist, wobei ein langes Einführungsblatt (503, 603) zwischen die Schichten der langen Harzfolie (501, 601) eingelegt ist;
Trennen des langen Einführungsblatts (503, 603) von der langen Harzfolie (501, 601), die von der lange Harzfolie-Abwickelrolle (500, 600) abgewickelt wird, und Aufwickeln des langen Einführungsblatts (503, 603) um eine lange Harzfolie-Wickelrolle (502, 602);
Überführen der langen Harzfolie (501, 601), von der das lange Einführungsblatt (503, 603) abgetrennt wurde, in ein Nassplattierungsbad (542, 543, 544, 545, 642, 643, 644, 645), um einen Metallfilm auf der Metallkeimschicht zu bilden; und
Aufwickeln der langen Harzfolie (501, 601) mit dem darauf gebildeten Metallfilm um eine lange Harzfolie-Wickelrolle (541, 641),
**dadurch gekennzeichnet, dass** das Verfahren die Durchführung einer Atmosphärendruck-Plasmareinigung auf einer Oberfläche der Metallkeimschicht auf der langen Harzfolie (501, 601) umfasst, von der das lange Einführungsblatt (503, 603) abgetrennt wurde, bevor die lange Harzfolie (501, 601) in das Nassplattierungsbad (542, 642) übertragen wird.

6. Verfahren zur Herstellung einer mit einem Metallfilm beschichteten Harzfolie nach Anspruch 5, **dadurch gekennzeichnet, dass** die Metallkeimschicht und der Metallfilm auf der langen Harzfolie (501, 601) Cu als Hauptbestandteil enthalten.

7. Verfahren zur Herstellung einer mit einem Metallfilm beschichteten Harzfolie nach Anspruch 5, **dadurch gekennzeichnet, dass** das lange Einführungsblatt (503, 603) aus Polyethylen, Polypropylen, Polyethylenterephthalat, Polyethylennaphthalat, Polystyrol, Polyvinylalkohol, Polycarbonat, Polyphenylensulfid, Polyetheretherketon, Polyethersulfon, Aramid, Polyimid oder Triacetat allein oder aus einem Verbundwerkstoff, bei dem welche davon miteinander laminiert sind, hergestellt ist.

8. Verfahren zur Herstellung einer mit einem Metallfilm beschichteten Harzfolie nach Anspruch 5, **dadurch gekennzeichnet, dass** eine Vorrichtung, die die Atmosphärendruck-Plasmareinigung auf der Oberfläche der Metallkeimschicht auf der langen Harzfolie (501, 601) durchführt, als eine ferngesteuerte Vorrichtung konfiguriert ist.

## Revendications

1. Appareil de fabrication de film de résine revêtu de film métallique comprenant :
un rouleau de déroulement de film de résine long (500, 600) autour duquel un film de résine long (501, 601) avec une couche d'amorce métallique déposée sur l'une ou les deux surfaces de celui-ci est enroulé avec une feuille d'insertion longue (503, 603) insérée entre des couches du film de résine long (501, 601) ;
un rouleau d'enroulement de feuille d'insertion longue (502, 602) qui sépare la feuille d'insertion longue (503, 603) du film de résine long (501, 601) déroulé depuis le rouleau de déroulement de film de résine long (500, 600) et enroule la feuille d'insertion longue (503, 603) ;
un bain de placage humide (542, 543, 544, 545, 642, 643, 644, 645) dans lequel le film de résine long (501, 601) duquel la feuille d'insertion longue (503, 603) a été séparée est transféré pour former un film métallique sur la couche d'amorce métallique ; et
un rouleau d'enroulement de film de résine long (541, 641) qui enroule le film de résine long (501, 601) avec le film métallique formé sur celui-ci,
**caractérisé en ce que** l'appareil comprend un appareil de nettoyage par plasma à pression atmosphérique qui nettoie une surface de la couche d'amorce métallique sur le film de résine long (501, 601) duquel la feuille d'insertion longue (503, 603) a été séparée, l'appareil de nettoyage par plasma à pression atmosphérique étant disposé entre le rouleau de déroulement de film de résine long (500, 600) et le bain de placage humide (542, 642).

2. Appareil de fabrication de film de résine revêtu de film métallique selon la revendication 1, **caractérisé en ce que** la couche d'amorce métallique et le film métallique sur le film de résine long (501, 601) contiennent Cu en tant que composant principal.

3. Appareil de fabrication de film de résine revêtu de film métallique selon la revendication 1, **caractérisé en ce que** la feuille d'insertion longue (503, 603) est constituée de polyéthylène, polypropylène, poly(téréphtalate d'éthylène), poly(naphtalate d'éthylène), polystyrène, alcool polyvinylique, polycarbonate, poly(sulfure de phénylène), polyéther-éther-cétone, polyéthersulfone, aramide, polyimide ou triacétate seuls, ou un composite quelconque de ceux-ci stratifiés les uns sur les autres.

4. Appareil de fabrication de film de résine revêtu de film métallique selon la revendication 1, **caractérisé en ce que** l'appareil de nettoyage par plasma à pression atmosphérique est d'un type actionné à distance.

5. Procédé de fabrication de film de résine revêtu de film métallique comprenant les étapes de :
déroulement d'un film de résine long (501, 601) avec une couche d'amorce métallique déposée sur l'une ou les deux surfaces de celui-ci depuis un rouleau de déroulement de film de résine long (500 600) autour duquel le film de résine long (501, 601) est enroulé avec une feuille d'insertion longue (503, 603) insérée entre des couches du film de résine long (501, 601) ;
séparation de la feuille d'insertion longue (503, 603) du film de résine long (501, 601) déroulé depuis le rouleau de déroulement de film de résine long (500, 600) et enroulement de la feuille d'insertion longue (503, 603) autour d'un rouleau d'enroulement de feuille d'insertion longue (502, 602) ;
transfert du film de résine long (501,601) duquel la feuille d'insertion longue (503, 603) a été séparée dans un bain de placage humide (542, 543, 544, 545, 642, 643, 644, 645) pour former un film métallique sur la couche d'amorce métallique ; et
enroulement du film de résine long (501, 601) avec le film métallique formé sur celui-ci autour d'un rouleau d'enroulement de film de résine long (541, 641),
**caractérisé en ce que** le procédé comprend la conduite d'un nettoyage par plasma à pression atmosphérique sur une surface de la couche d'amorce métallique sur le film de résine long (501, 601) duquel la feuille d'insertion longue (503, 603) a été séparée, avant que le film de résine long (501, 601) soit transféré dans le bain de placage humide (542, 642).

6. Procédé de fabrication de film de résine revêtu de film métallique selon la revendication 5, **caractérisé en ce que** la couche d'amorce métallique et le film métallique sur le film de résine long (501, 601) contiennent Cu en tant que composant principal.

7. Procédé de fabrication de film de résine revêtu de film métallique selon la revendication 5, **caractérisé en ce que** la feuille d'insertion longue (503, 603) est constituée de polyéthylène, polypropylène, poly(téréphtalate d'éthylène), poly(naphtalate d'éthylène), polystyrène, alcool polyvinylique, polycarbonate, poly(sulfure de phénylène), polyéther-éther-cétone, polyéthersulfone, aramide, polyimide ou triacétate seuls, ou un composite quelconque de ceux-ci stratifiés les uns sur les autres.

8. Procédé de fabrication de film de résine revêtu de film métallique selon la revendication 5, **caractérisé en ce qu'**un appareil qui effectue le nettoyage par plasma à pression atmosphérique sur la surface de la couche d'amorce métallique sur le film de résine long (501, 601) est configuré sous la forme d'un appareil de type commandé à distance.
